# EUROPEAN PATENT APPLICATION

(11) **EP 0 600 590 A1**
(43) Date of publication of application: **08.06.1994**
(21) Application number: 93307801.6
(22) Date of filing: 30.09.1993
(51) Int. Cl.: H01L 23/36

(54) **Cooling electronic circuit assemblies**

(30) Priority: 03.12.1992 GB 9225260
(71) Applicant: INTERNATIONAL COMPUTERS LIMITED, Putney, London, SW15 1SW (GB)
(72) Inventor: Hamilton, Phillip George Brereton, Congleton, Cheshire CW12 4PQ (GB)
(74) Representative: Guyatt, Derek Charles

(57) **Abstract**

An electronic circuit assembly comprises a multi-layer printed circuit board (10) having an internal thermally conductive plane (12), such as a ground plane. First (18) and second (24) sets of thermally conductive vias extend through the circuit board (10) and make thermal contact with the thermally conductive plane (12). An electronic component (14) is mounted on the circuit board (10) in thermal contact with the first set of thermally conductive vias (18), and a heatsink (22) is mounted on the circuit board (10) in thermal contact with the second set of thermally conductive vias (24). Thus, heat generated by the component (14) can pass through the first set of vias (18), the internal thermally conductive plane (12), and the second set of vias (24), to the heatsink (22). This provides greater flexibility in the positioning of the component (14) and heatsink (22).

## Description

### Background to the Invention

This invention relates to the cooling of electronic circuit assemblies. The invention is particularly concerned with cooling circuit components, such as integrated circuit chips, mounted on a circuit board.

One known method for cooling a circuit component is to attach a heatsink directly to the component. Another known technique is to provide a set of thermally conductive vias extending through the circuit board. The component is mounted on one side of the board, in thermal contact with the vias, and a heatsink is mounted on the opposite side of the board, in thermal contact with the other end of the vias. The use of thermally conductive vias for component cooling is described in US Patent No. 4739448.

However, both of these methods suffer from the problem that the position of the heatsink is fixed in relation to the component, and may therefore interfere with the positioning of other components on the circuit board or adjacent boards. The object of this invention is to provide a cooling technique which allows greater flexibility in the positioning of heatsinks.

### Summary of the Invention

According to the invention there is provided an electronic assembly comprising:
(a) a circuit board comprising a plurality of planes including at least one thermally conductive plane,
(b) at least first and second thermally conductive columns extending through the circuit board and making thermal contact with the thermally conductive plane,
(c) an electronic component mounted on the circuit board in thermal contact with the first thermally conductive column, and
(d) a heatsink mounted on the circuit board in thermal contact with the second thermally conductive column, whereby heat generated by the component can pass through the first column, the thermally conductive plane, and the second column, to the heatsink.

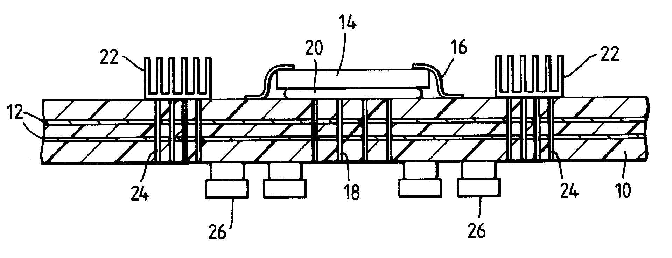

### Brief Description of the Drawing

The drawing is a sectional elevation of a printed circuit assembly.

### Description of an Embodiment of the Invention

One circuit assembly in accordance with the invention will now be described by way of example with reference to the accompanying drawing.

The circuit assembly comprises a multi-layer printed circuit board 10. The board includes a number of signal planes, power planes and ground planes, separated by dielectric layers. For simplicity, only the ground planes 12 are shown in the drawing.

The circuit board 10 has a number of components 14 mounted on it (only one shown). In this example, the components 14 comprise integrated circuit chips, mounted on ceramic chip carriers. However, it should be noted that other types of chip packaging may be used: for example, TAB packaging (tape automated bonding). Each component 14 has a number of leads 16 which make electrical connections with conductive pads on the surface of the circuit board, these pads being electrically connected to the tracks in the signal layers of the board by way of conductive vias. These electrical connections to the components are conventional and so are not shown in detail in the drawing.

Each component 14 is mounted above a set of thermally conductive vias 18 which extend through the thickness of the circuit board 10, making thermal contact with the ground planes 12. Each component 14 is attached to the top of its corresponding set of vias 18, by means of a thermally conductive epoxy resin 20, to ensure good thermal contact between the component and the vias.

The board also has a number of heatsinks 22 mounted on it. In this example the heatsinks are mounted on the same side of the board as the components 14, although in other embodiments they may be mounted on the opposite side. Each of these heat sinks consists of an aluminium extrusion, comprising a base portion and a set of fins extending upwards from the base.

Each of the heatsinks 22 is mounted above a set of thermally conductive vias 24 which extend through the circuit board making thermal contact with the ground planes 12. Each heatsink 22 is flow soldered onto the top of the corresponding set of vias, to ensure good thermal contact between the heatsink and the vias. Alternatively, the heatsinks 22 may have pins extending from their base portions and soldered into the vias 24.

Each of the vias 18, 24 may be formed, for example, by drilling a hole through the board and internally plating the hole with copper, such that the copper is in contact with the ground planes 12.

It can be seen that heat generated by the components 14 can therefore pass through the vias 18, the ground planes 12, and the vias 24 to the heatsinks 22, allowing the heat be dissipated by air cooling.

Because the ground planes 12 provide heat paths, it may be necessary for these planes to be thicker than would normally be necessary for a ground plane. In this example, the ground planes 12 are 2oz copper, ie 2 ounces of copper per square foot (0.61kg per square metre).

It can be seen that there is considerable flexibility in the positioning of the heatsinks 22 relative to the components 14 to be cooled. Thus, the heatsinks can be positioned so as not to interfere with the positioning of other components on the board; that is, the heatsinks can be located in otherwise unoccupied areas of the board.

Moreover, because the heatsinks are on the same side of the board as the components 14, other components 26 not requiring cooling may be positioned on the other side of the board opposite the component 14. This is useful where for example it is desired to position a number of cache memory components 26 physically close to a processor component 14.

Where a particular component 14 generates a large amount of heat, it may be surrounded by a ring of heatsinks 22, thus effectively thermally insulating the component 14 from other components on other parts of the board.

It should be noted that, although in the example described, above, ground planes are used for heat conduction, in other embodiments of the invention other planes, such as power planes, may be used for this purpose.

## Claims

1. An electronic circuit assembly comprising:
(a) a circuit board comprising a plurality of planes including at least one thermally conductive plane,
(b) at least first and second thermally conductive columns extending through the circuit board and making thermal contact with the thermally conductive plane,
(c) an electronic component mounted on the circuit board in thermal contact with the first thermally conductive column, and
(d) a heatsink mounted on the circuit board in thermal contact with the second thermally conductive column, whereby heat generated by the component can pass through the first column, the thermally conductive plane, and the second column, to the heatsink.

2. An assembly according to Claim 1 wherein each thermally conductive column comprises a plurality of thermally conductive vias extending through the circuit board.

3. An assembly according to Claim 2 wherein each of said vias comprises an internally plated through-hole.

4. An assembly according to any preceding claim wherein said thermally conductive plane is electrically conductive and also acts as a ground plane for the circuit board.

5. An assembly according to any preceding claim wherein said thermally conductive plane is internal to the circuit board.

6. An assembly according to any preceding Claim wherein said heatsink and component are both mounted on the same side of the circuit board.

7. An electronic circuit assembly comprising:
(a) a circuit board comprising a plurality of planes including a thermally conductive plane,
(b) first and second sets of thermally conductive vias extending through the circuit board and making thermal contact with the thermally conductive plane,
(c) an electronic component mounted on the circuit board in thermal contact with the first set of thermally conductive vias, and
(d) a heatsink mounted on the circuit board in thermal contact with the second set of thermally conductive vias, whereby heat generated by the component can pass through the first set of vias, the thermally conductive plane, and the second set of vias, to the heatsink.

8. An assembly according to Claim 7 wherein said thermally conductive plane is an electrical ground plane.

9. An assembly according to Claim 7 or 8 wherein said thermally conductive plane is internal to said circuit board.
